# NEUE EUROPÄISCHE PATENTSCHRIFT

(11) **EP 2 505 931 B2**
(45) Veröffentlichungstag und Bekanntmachung des Hinweises auf die Entscheidung über den Einspruch: **12.01.2022**
(45) Hinweis auf die Patenterteilung: 01.07.2015
(21) Anmeldenummer: 11002637.4
(22) Anmeldetag: 30.03.2011
(51) Int. Cl.: F24H 1/12, F24H 1/00, H05K 3/20, H05K 3/32, F24H 3/04

(54) **Elektrische Heizvorrichtung mit einem Leiterbahnen aufweisenenden Plattenelement und Verfahren zur Herstellung eines solchen Plattenelementes**
Electric heating device with a plate element comprising conducting tracks and method for producing such a plate element
Dispositif de chauffage électrique doté d'un élément plat comprenant des pistes conductrices et procédé de fabrication d'un tel élément plat

(43) Veröffentlichungstag der Anmeldung: 03.10.2012
(60) Teilanmeldung: 13001950.8
(73) Patentinhaber: Eberspächer catem GmbH & Co. KG, 76863 Herxheim bei Landau (DE)
(72) Erfinder: Bohlender, Franz, 75870 Kandel (DE); Walz, Kurt, 76767 Hagenbach (DE); Götzelmann, Robert, 76187 Karlsruhe (DE); Niederer, Michael, 76889 Kapellen Drusweiler (DE); Emanuel, Dieter, 76855 Annweiler (DE)
(74) Vertreter: Grünecker Patent- und Rechtsanwälte PartG mbB

(56) Entgegenhaltungen:
- EP-A1- 1 580 495
- EP-A1- 1 580 495
- EP-A1- 1 872 986
- EP-A1- 2 236 330
- DE-A1-102009 026 459
- DE-A1-102009 026 459
- FR-A1- 2 344 151
- FR-A1- 2 642 573
- US-A1- 2008 000 889
- US-A1- 2008 057 773
- US-A1- 2009 020 619
- US-A1- 2010 112 862
- US-A1- 2010 122 978
- US-A1- 2010 243 638

## Beschreibung

Die vorliegende Erfindung betrifft eine elektrische Heizvorrichtung mit mehreren elektrischen Heizelementen, die von einem Gehäuse gehalten werden und an Wärmeleitflächen anliegen, die von zu erwärmendem Medium anströmbar sind. Die Heizelemente der elektrischen Heizvorrichtung sind für deren elektrischen Anschluss mit Kontaktzungen versehen. Sämtliche oder einige dieser Kontaktzungen sind im Wesentlichen höhengleich angeordnet und über ein Plattenelement angeschlossen, welches mit Leiterbahnen versehen ist und zur elektrischen Kontaktierung der Kontaktzungen Kontaktzungenaufnahmen aufweist.

Eine solche elektrische Heizvorrichtung ist beispielsweise aus der auf die Anmelderin zurückgehenden EP 1 872 986 A1 bekannt. Bei diesem Stand der Technik bildet das Gehäuse eine Kammer aus, in der die Wärme der elektrischen Heizelemente an ein flüssiges Medium übertragen wird. Die elektrischen Heizelemente liegen hierzu in mehreren U-förmig ausgebildeten Heizkammem und stehen wärmeleitend in Kontakt mit den Wandungen der Heizkammern, die außenseitig von der Flüssigkeit angeströmt werden.

Eine gattungsgemäße elektrische Heizvorrichtung kann aber auch durch einen elektrischen Zuheizer zur Erwärmung von Luft des Fahrzeuginnenraumes gebildet sein. In diesem Fall wird das Gehäuse üblicherweise durch einen Rahmen ausgeformt, in dem mehrere elektrische Heizelemente in einem Schichtaufbau gehalten sind, der Radiatorelemente umfasst, die an den elektrischen Heizelementen anliegen und von der zu erwärmenden Luft durchströmt werden. Die elektrischen Heizelemente umfassen auch hier PTC-Elemente mit beidseitig daran anliegenden Blechbändern. Einzelne Blechbänder sind zur Ausbildung von Kontaktzungen seitlich über den Schichtaufbau hinausgeführt. Eine solche elektrische Heizvorrichtung ist beispielsweise durch die EP 1 157 867 A1 beschrieben.

Die EP 1 580 495 A1 offenbart eine elektrische Heizvorrichtung mit mehreren elektrischen Heizelementen, die von einem Gehäuse gehalten werden und an Wärmeleitflächen anliegen. Die elektrischen Heizelemente haben für den elektrischen Anschluss im Wesentlichen höhengleich angeordnete Kontaktzungen. Ein Plattenelement mit einer Trägerplatte und einer Metallplatte weist Aufnahmen für den elektrischen Anschluss von Vierkantrohren auf, welche jeweils PTC-Elemente und ein Kontaktblech aufnehmen, an dessen freiem Ende die Kontaktzunge ausgeformt ist, welche das Vierkantrohr überragt.

Die Kontaktzungen dieser Heizvorrichtung sind in Rechtecksprofilrohren beführt. Die Rechtecksprofilrohre bilden einen negativen Pol die Kontaktzungen einen positiven Pol, über welchen jeweils ein zwischen der Kontaktzunge und dem Rechteckprofilrohr gehaltenes PTC-Element kontaktiert ist. Die Kontaktzungen überragen die Rechtecksprofilrohre und sind einzeln über Zuleitungen kontaktiert, während die Rechtecksprofilrohre über eine Metallplatte, in welcher die Rechtecksprofilrohre in Aufnahmelöchern stecken, kontaktiert sind. So ist eine Kontaktierung in zwei Ebenen vorgesehen. Die Metallplatte ist zwischen einer Trägerplatte und einem Trägerplattekopf gepresst gehalten und so am Herausfallen gehindert.

Bei den gattungsgemäßen Heizvorrichtungen besteht die Notwendigkeit einer einfachen Kontaktierung der elektrischen Heizelemente. Dabei gilt, dass die elektrischen Heizelemente üblicherweise in dem Gehäuse vormontiert werden, bevor ein elektrischer Anschluss der elektrischen Heizelemente erfolgt. So wird regelmäßig eine Steckverbindung gefordert, die einen einfachen aber effektiven und dauerhaften elektrischen Anschluss an die Kontaktzungen der elektrischen Heizelemente erlaubt.

Die aus der EP 1 872 986 A1 bekannte elektrische Heizvorrichtung hat mehrere in parallelen Reihen vorgesehene elektrische Heizelemente. Jedes einzelne Heizelement hat zwei Kontaktzungen, die jeweils über das Plattenelement angeschlossen werden müssen. Die EP 1 872 986 A1 offenbart hierzu eine Leiterplatte mit Leiterbahnen für die jeweiligen Kontaktzungen und Kontaktzungenaufnahmen, die elektrisch mit den Leiterbahnen verbunden sind, verschiedene Kontaktzungen zu einem Heizkreis gruppiert und darüber hinaus Flachstecker trägt. Diese Flachstecker sind in Aufnahmen einer weiteren Leiterplatte eingebracht und elektrisch mit dieser verbunden, die die Schaltung zum Steuern bzw. Regeln der elektrischen Heizvorrichtung umfasst und über welche die einzelnen Heizkreise geschaltet werden können.

Die Herstellung einer Leiterplatte ist indes kostenintensiv. Darüber hinaus erlaubt die Leiterplatte wegen der darin fest vorgegebenen Leiterbahnen keine Anpassung zur Ausbildung unterschiedlicher Heizkreise bzw. unterschiedlicher Leiterbahnen. Des Weiteren sind beispielsweise die Kontaktzungenaufnahmen auf die Leiterplatte angelötet und so mit den Leiterbahnen elektrisch verbunden. Dies erfordert nicht nur ein aufwendiges Herstellungsverfahren, sondern begrenzt darüber hinaus die Einsatztemperatur des vorbekannten Plattenelementes.

Bei der aus der EP 1 580 495 A1 bekannten elektrischen Heizvorrichtung besteht das Problem, dass zum einen die Kontaktierung der einzelnen Kontaktzungen mit dem Pluspol des Netzteils aufwändig ist, zum anderen muss die Metallplatte und deren Fixierung in einem komplexen Produktions-Schritt zwischen der Trägerplatte und dem Trägerplattenkopf verschraubt werden. Die ebenso komplexe Geometrie der Heizelemente mit den in Rechteckprofilen geführten Kontaktzungen macht zumal eine einfache Kontaktierung der Rechteckprofile und der Kontaktzungen mit einer ausreichenden Isolation schwierig. Hierzu müssen zum Beispiel die einzelnen leitenden Verbindungen der Plus- bzw. Minuspole in unterschiedlichen Ebenen vorgesehen sein.

Die vorliegende Erfindung will ein Leiterbahnen aufweisendes Plattenelement angeben, welches sich einfacher und kostengünstiger herstellen lässt.

Zur Lösung des vorrichtungsmäßigen Problems wird mit der vorliegenden Erfindung eine elektrische Heizvorrichtung mit den Merkmalen von Anspruch 1 angegeben.

Die Trägerplatte wird üblicherweise aus einem elektrisch nicht leitenden Kunststoff, vorzugsweise mittels Spritzgießen hergestellt, so dass die Trägerplatte weitere Funktionsflächen oder -elemente aufweisen kann, die den Einbau in oder an das Gehäuse, die der Vervollständigung des Gehäuses oder aber der Montage weiterer Bauteile wie Elektronik oder Kabelführung dienen, erlauben. Als Kunststoff kommt dabei beispielsweise Procan, PPT GF30 (CTI 600) oder ein anderer, relativ Wärme beständiger Kunststoff in Betracht. Dies bietet die Möglichkeit, das Plattenelement höheren Temperaturen auszusetzen, insbesondere dann, wenn die elektrische Anbindung an die Metallplatte lediglich über Stecken und ohne jegliche Lötverbindung erfolgt. Das die strukturelle Integrität des Plattenelementes ausbildende Bauteil, d.h. die Trägerplatte kann beliebig und lediglich begrenzt durch die Möglichkeiten der spritzgießtechnischen Herstellung ausgeformt sein. Die Leiterbahnen werden indes bei dem erfindungsgemäßen Plattenelement durch eine stanzbearbeitete Metallplatte ausgeformt. Diese stanzbearbeitete Metallplatte kann kostengünstig vorbereitet und danach mit der Trägerplatte verbunden werden.

Das Fügen von verschiedenen Bauteilen zur elektrischen Anbindung der elektrischen Heizelemente an das Plattenelement kann dadurch verhindert werden, dass die Kontaktzungenaufnahmen einteilig durch Stanzen und Biegen an der Metallplatte ausgeformt sind, wie dies mit einer Weiterbildung vorgeschlagen wird. Die Metallplatte ist hierzu vorzugsweise aus einem federharten, gut kontaktierbarem Material gebildet, wie beispielsweise aus CuSnNi1 Mg, welches mit einer dünnen Beschichtung von wenigen µm Silber und/oder Kupfer/Zinn beschichtet ist. Die Kontaktzungenaufnahmen haben dabei zur definierten Kontaktierung der Kontaktzungen an gegenüberliegende Seitenflächen der Kontaktzungen anlegbare Kontaktfedern, die unter vorbestimmter Vorspannung gegen die Kontaktzungen anliegen.

Die Erfindung bietet daher die Möglichkeit, die Leiterbahnen sowie die zum Anschluss der Kontaktzungen notwendigen Elemente einteilig durch Stanzen und biegen einer Metallplatte auszubilden, die zur Versteifung und zur Positionierung an dem Gehäuse mit der hierfür speziell ausgeformten und aus kostengünstigem Kunststoff hergestellten Trägerplatte verbunden wird.

Zur weiteren Vereinfachung des elektrischen Anschlusses wird gemäß einer bevorzugten Weiterbildung der vorliegenden Erfindung vorgeschlagen, zumindest einen Flachstecker vorzusehen, der von einem einteilig an der Trägerplatte ausgeformten Flachsteckerhalter gehalten ist. Der bzw. die Flachstecker überragen üblicherweise die Trägerplatte einseitig und zwar in der Regel auf der der Metallplatte abgewandten Oberseite. Zur elektrischen Kontaktierung des Flachsteckers weist die Metallplatte eine korrespondierend zu dem Flachstecker ausgebildete Flachsteckerkontaktaufnahme aus. Auch diese Flachsteckerkontaktaufnahme ist vorzugsweise mit Kontaktfedern versehen, so dass eine elektrische Kontaktierung des Flachsteckers allein durch Einstecken desselben in die Flachsteckerkontaktaufnahme erfolgt.

Nach alledem weist die stanzbearbeitete Metallplatte des Plattenelementes nach der vorliegenden Erfindung vorzugsweise lediglich durch Stanzen herausgeschnittene Leiterbahnen sowie Aufnahmen für die Kontaktzungen einerseits und die Flachstecker andererseits auf, über welche unmittelbar eine elektrische Kontaktierung mit den Leiterbahnen beim Einstecken der Kontaktzungen bzw. der Flachstecker erfolgt. Das Plattenelement der vorliegenden Erfindung lässt sich daher leicht mit den elektrischen Heizelementen einerseits und einer Stromversorgung bzw. einer Schaltung hierzu kontaktieren. Das Plattenelement mit den Merkmalen von Anspruch 1 sowie die Weiterbildung nach den hiervon abhängigen Ansprüchen kann auch für sich allein und ohne die elektrische Heizvorrichtung erfindungswesentlich sein.

Der Flachstecker ist vorzugsweise aus einem Blechstreifen gebildet und hat zumindest einen von der Seitenflächen des Blechstreifens abragenden und durch Stanzen und Biegen hergestellten Verriegelungsvorsprung. Über diesen Verriegelungsvorsprung ist der Flachstecker mit dem Flachsteckerhalter verrastet. Üblicherweise weist der Flachsteckerhalter hierzu einen Hinterschnitt auf, der im Anschluss an einen Einführ- und Haltekanal für den Flachstecker ausgeformt ist und in welchen der Verriegelungsvorsprung hereinfedert, nachdem der Verriegelungsvorsprung den besagten Kanal passiert hat. Der Verriegelungsvorsprung verhindert danach ein Herausziehen des Flachsteckers in entgegen gesetzter Richtung durch Anlage an den Hinterschnitt.

Erfindungsgemäß sind zur einfachen Verbindung zwischen der Trägerplatte und der stanzbearbeiteten Metallplatte an der Trägerplatte einteilig ausgeformte Halteelemente vorgesehen, über welche die Metallplatte mit der Trägerplatte verrastet werden kann. Die Fügebewegung führt danach zu einer formschlüssigen Verbindung zwischen der stanzbearbeiteten Metallplatte und der Trägerplatte.

Die Trägerplatte hat dabei mehrere entsprechende Halteelemente, die einteilig an der Trägerplatte ausgeformt sind. Diese übergreifen üblicherweise zumindest den Randbereich der stanzbearbeiteten Metallplatte.

Zur sicheren und vollflächigen Befestigung der Metallplatte an dem Trägerelement weist die Metallplatte eine dem Halteelement zugeordnete Halteöffnung auf, die von dem Halteelement zum Verrasten gegen die Metallplatte durchsetzt ist. Regelmäßig weist die stanzbearbeitete Metallplatte mehrere solcher Halteöffnungen auch in ihrem mittleren Flächenbereich auf. Damit wird die stanzbearbeitete Metallplatte nicht nur randseitig, sondern auch in ihrem mittleren Bereich und vorzugsweise über deren gesamte Längserstreckung an verschiedenen Stellen an der Trägerplatte verrastet und somit sicher an dieser gehalten.

Eine besonders sichere Verrastung ergibt sich gemäß einer bevorzugten Weiterbildung der vorliegenden Erfindung, bei welcher die Halteöffnung im Wesentlichen mittig von einem Halteelementsteg überbrückt ist, der einteilig an der Trägerplatte ausgeformt ist und von dem beidseitig daran angeformte Federstege und daran vorgesehene und die Metallplatte hintergreifende Rastnasen abragen.

Gemäß einer weiteren bevorzugten Weiterbildung der vorliegenden Erfindung hat die Metallplatte mehrere, einem Heizkreis der elektrischen Heizvorrichtung zugeordnete und die elektrischen Leiterbahnen gruppierende Flächenelemente. Diese Flächenelemente sind zunächst durch Verbindungsstege miteinander verbunden, so dass die Metallplatte als einheitliches Bauteil durch Stanzen und Biegen vorbereitet werden kann. Jedem einzelnen Flächenelement ist zumindest einer der Flachstecker zugeordnet. Die Trägerplatte weist Stanzöffnungen aus, welche die Verbindungsstege freilassen. Der Verbindungssteg durchsetzt üblicherweise in etwa mittig eine entsprechende Stanzöffnung. Die üblicherweise mittels Spritzgießen ausgeformte Stanzöffnung erlaubt das Durchtrennen der Verbindungsstege nach der Montage der stanzbearbeiteten Metallplatte, um die einzelnen Flächenelemente elektrisch voneinander zu isolieren. Dabei ist üblicherweise jedem einzelnen Flächenelement auf Seiten der Trägerplatte zumindest eines der Halteelemente zugeordnet.

Vorzugsweise wird das die Leiterbahnen aufweisende Plattenelement hergestellt, indem zunächst die Metallplatte zur Ausformung der Leiterbahnen sowie von über Verbindungsstege miteinander verbundenen Flächenelemente und den in den Flächenelementen vorgesehenen Kontaktzungenaufnahmen stanzbearbeitet bzw. stanz-biege-bearbeitet wird. Erst danach erfolgt das Fügen mit der Trägerplatte. Diese wird erfindungsgemäß mittels Spritzgießen aus Kunststoff hergestellt. Erst nach dem Fügeprozess werden die Verbindungsstege durchtrennt, um die zuvor einheitlich hergestellten und miteinander verbundenen Flächenelemente elektrisch zu isolieren. Regelmäßig wird die Trägerplatte zunächst unabhängig von der Metallplatte hergestellt. Es ist aber nicht auszuschließen, dass beide Bauelemente durch Umspritzen der Metallplatte gefügt und dabei gleichzeitig die Trägerplatte hergestellt wird.

Beim Fügen wird vorzugsweise jedes Flächenelement formschlüssig mit der Trägerplatte verbunden, um die einzelnen Flächenelemente auch nach dem Durchtrennen der Verbindungsstege sicher an der

Inbesondere wird der Flachstecker nach dem Fügen von Trägerplatte und Metallplatte in den zugeordneten Flachsteckerhalter eingeschoben. Am Ende dieser Einschiebebewegung, welches üblicherweise durch einen an dem Flachstecker ausgeformten Steckanschlag vorgegeben ist, verrastet der Flachstecker in dem Flachsteckerhalter und an dem Plattenelement ausgeformte Flachsteckerkontaktaufnahmen werden elektrisch mit den zugehörigen Flachsteckern als Steckverbindung kontaktiert. Folglich ergibt sich im Rahmen der Einschiebebewegung sowohl eine mechanische Befestigung des Flachsteckers wie auch eine elektrische Ankopplung an die stanzbearbeitete Metallplatte.

Weitere Einzelheiten und Vorteile der vorliegenden Erfindung ergeben sich aus der nachfolgenden Beschreibung eines Ausführungsbeispiels in Verbindung mit der Zeichnung. In dieser zeigen:
- Figur 1: eine perspektivische Explosionsdarstellung einer oberseitigen Ansicht eines Plattenelementes nach dem Ausführungsbeispiel;

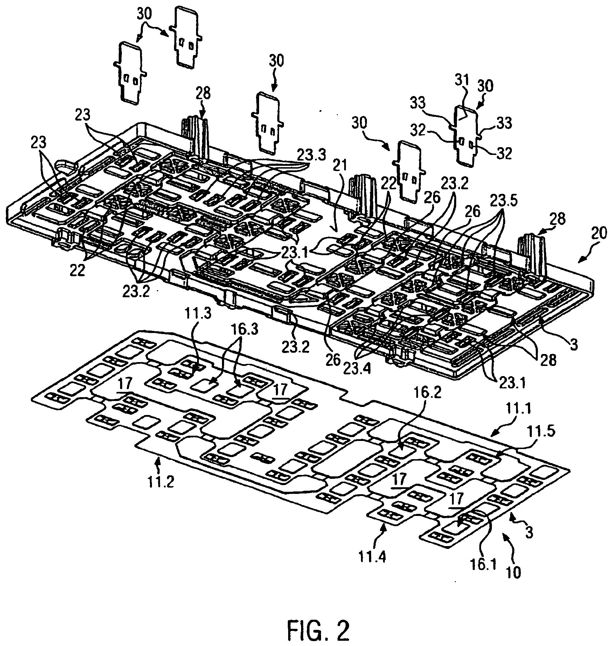

- Figur 2: eine perspektivische Explosionsdarstellung einer unterseitigen Ansicht eines Plattenelementes nach dem Ausführungsbeispiel;
- Figur 3: eine perspektivische Draufsicht auf die Oberseite des in den Figuren 1 und 2 gezeigte Ausführungsbeispiel nach dem Fügen sämtlicher Bauteile;
- Figur 4: eine perspektivische Draufsicht auf die Unterseite des in den Figuren 1 und 2 gezeigte Ausführungsbeispiel nach dem Fügen sämtlicher Bauteile;
- Figur 5: eine Schnittansicht entlang der Linie V-V gemäß Figur 3;
- Figur 6: eine Schnittansicht entlang der Linie VI-VI gemäß der Darstellung in Figur 3 und
- Figur 7: das Detail VII gemäß Figur 3.

Bei dem in den Figuren verdeutlichten Bauteil handelt es um das Plattenelement einer an sich beispielsweise aus der EP 1 872 986 A1 bekannten elektrischen Heizvorrichtung mit mehreren in parallelen Reihen angeordneten elektrischen Heizelementen. Auf die spezielle Beschreibung der EP 1 872 986 A1 wird insofern verwiesen. Der Offenbarungsgehalt dieser Patentanmeldung wird durch Bezugsnahme in den Offenbarungsgehalt der vorliegenden Anmeldung aufgenommen. In der nachfolgenden speziellen Beschreibung wird lediglich näher auf das in der EP 1 872 986 A1 als Verteilerplatte bezeichnete Bauteil eingegangen.

Dieses Plattenelement ist in den Figuren mit Bezugszeichen 1 gekennzeichnet und besteht aus einer Metallplatte 10, einer Trägerplatte 20 und mehreren Flachsteckern 30.

In den Figuren wird des Weiteren mit Bezugszeichen 2 die Oberseite und mit Bezugszeichen 3 die Unterseite des jeweiligen Bauteils gekennzeichnet.

Die Metallplatte 10 ist durch Stanzen und Biegen eines federharten Kontaktmaterials wie beispielsweise CuSnNi1Mg mit einer 2,5 µm dicken Silberbeschichtung gebildet. Durch die Stanzbearbeitung ist die Metallplatte zu einer gitterförmigen Ausgestaltung umgeformt. Die Metallplatte 10 hat fünf Flächenelemente 11, die jeweils über Verbindungsstege 12 miteinander verbunden sind. Jedes Flächenelement 11 hat mehrere Kontaktzungenaufnahmen 13, die durch Freischneiden einer Einbringöffnung unter Stehenlassen von Kontaktfedern 14, die von gegenüberliegenden Seitenrändern der Einbringöffnung abragen, gebildet ist. Durch Biegen sind diese freigestanzten Kontaktfedern zur Oberseite 2 der Metallplatte 10 hin gerichtet, so dass sich von der Unterseite 3 her eine leicht trichterförmige Verengung zu den Spitzen der Kontaktfedern 14 ergibt.

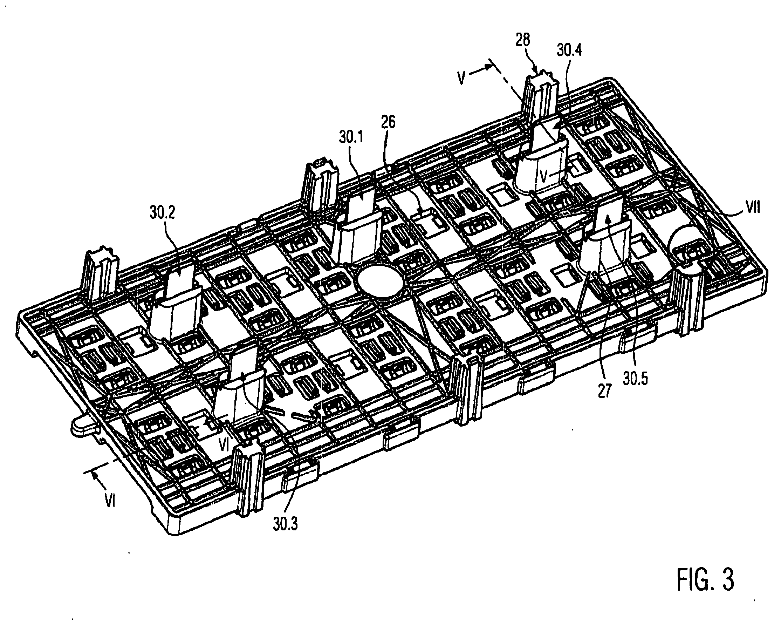

Mit entsprechenden Kontaktfedern 14 sind auch die mit Bezugszeichen 15 gekennzeichneten Flachsteckerkontaktaufnahmen versehen. Zu jedem Flächenelement 11.1 bis 11.5 ist je eine Flachsteckerkontaktaufnahme 15.1 bis 15.5 vorgesehen (Fig. 3).

Durch Stanzen sind ferner an der Metallplatte 10 rechteckige Halteöffnungen 16 sowie Innenöffnungen 17 ausgeformt. Das verbleibende Material der Metallplatte 10 bildet teilweise stegförmige, teilweise flächige Leiterbahnen 18 aus. Sämtliche Funktionselemente und - flächen der Metallplatte 10 sind allein durch Stanz- bzw. Stanz-Biege-Bearbeitung eines tafelförmigen Blechhhalbzeugs ausgebildet.

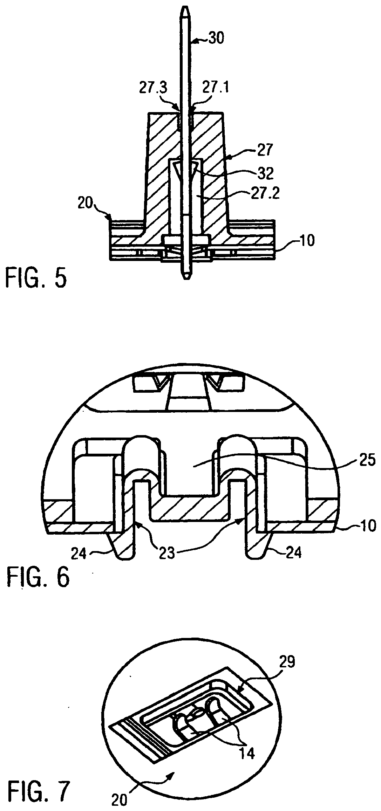

Die Trägerplatte 20 bildet eine ebene Anlagefläche 21 für die Metallplatte 10 aus, die von in die Innenöffnungen 17 der Metallplatte 10 hineinragenden Versteifungssegmenten 22 überragt ist. Die Kontur der Versteifungssegmente 22 entspricht im Wesentlichen der Randkontur der zugeordneten Flächenelemente 11, so dass die Metallplatte 10 relativ zu der Trägerplatte 20 ausgerichtet wird und die Metallplatte 10 nur in vorgegebener Ausrichtung relativ zu der Trägerplatte 20 an diese angelegt werden kann. Die Anlagefläche 21 wird ferner von Federstegen 23 mit Rastnasen 24 überragt, die in Figur 6 vergrößert gezeigt sind und Halteelemente zur formschlüssigen Halterung der Metallplatte 10 an der Trägerplatte 20 ausbilden. Die Federstege 23 und die Rastnasen 24 durchragen hierfür die Halteöffnungen 16 und die Rastnasen 24 hintergreifen die Unterseite 3 der Metallplatte 10. Die Federstege 23 gehen von einem Halteelementsteg 25 ab, welcher nach dem Fügen von Metallplatte 10 und Trägerplatte 20 die Halteöffnungen 16 in etwa mittig überbrückt (vgl. Figur 6). Die Anlagenflächen 21. 4 und 21.5 für die Flächenelemente 11.4 und 11.5 sind randseitig durch Federstege 23.4, 23.5 mit zugeordneten Rastnasen begrenzt, die im gefügten Zustand mit den Seitenrändern der entsprechenden Flächenelemente 11.4 und 11.5 zusammenwirken und diese formschlüssig fixieren.

Auch die Außenkontur der Metallplatte 10 ist über Federstege 23 formschlüssig umgriffen.

Der Lage der Verbindungsstege 12 korrespondierend weist die Trägerplatte 20 Stanzöffnungen 26 auf. Im gefügten Zustand befinden sich die Verbindungsstege 12 in etwa mittig in diesen Stanzöffnungen 26.

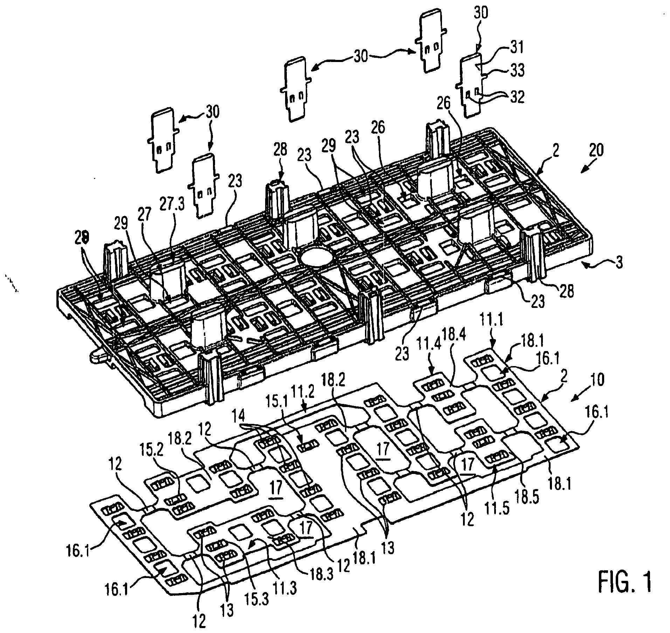

Die in Figur 1 zu erkennende Oberseite 2 der Trägerplatte 20 wird von fünf Flachsteckerhaltern 27 sowie je drei auf der Längsseite verteilt vorgesehenen Auflagern 28 überragt, die höhengleich mit den Flachsteckerhaltern 27 enden. Jeder Flachsteckerhalter 27 hat einen an die Dicke des Flachsteckers 30 angepasst ausgebildeten Einführkanal 27.1, der zu einem Aufnahmebereich 27.2 führt, der umfänglich von dem die Trägerplatte 20 ausbildenden Kunststoffmaterial umgeben ist und einen Hinterschnitt ausbildet. Korrespondierend zu den Kontaktzungen - bzw. Flachsteckerkontaktaufnahmen 13, 15 sind an der Trägerplatte 20 schließlich Kontakteinbringöffnungen 29 ausgespart.

Sämtliche zuvor beschriebenen Elemente der Trägerplatte 20 sind einteilig an dieser im Wege des Spritzgießens der Trägerplatte 20 ausgeformt.

Der Flachstecker 30 hat von gegenüberliegenden Seitenflächen 31 abragende Verriegelungsvorsprünge 32, die durch Freistanzen und Herausbiegen aus der Blechebene des Flachsteckers 30 ausgebildet sind. Des Weiteren ragen quer von dem Flachstecker 30 Steckanschläge 33 ab, für deren Aufnahme die freie Stirnseite der Flachsteckerhalter 27 mit einer Nut 27.3 versehen sind.

Bei dem gezeigten Ausführungsbeispiel wird zunächst die Trägerplatte 20 einteilig mittels Spritzgießen aus einem warmfesten Kunststoff, beispielsweise PBT hergestellt. Die Metallplatte 10 wird durch Stanzen und Biegen vorbereitet. Danach werden die beiden Bauteile 10, 20 relativ zueinander positioniert. Die Trägerplatte 20 ist dabei üblicherweise mit ihrer Unterseite 3 nach oben gerichtet. Nach dem Auflegen der Metallplatte 10 drückt ein Fügewerkzeug die Metallplatte 10 gegen die Anlageflächen 21 der Trägerplatte 20. Dabei verrasten die Rastnasen 24 gegen die Ränder der Halteöffnungen 16 bzw. gegen den Längsrand der Flächenelemente 11.4, 11.5. In gleicher Weise verrasten am Längsrand der Trägerplatte 20 vorgesehene Federstege 23 gegen die Metallplatte 10 entlang ihrer Außenkontur.

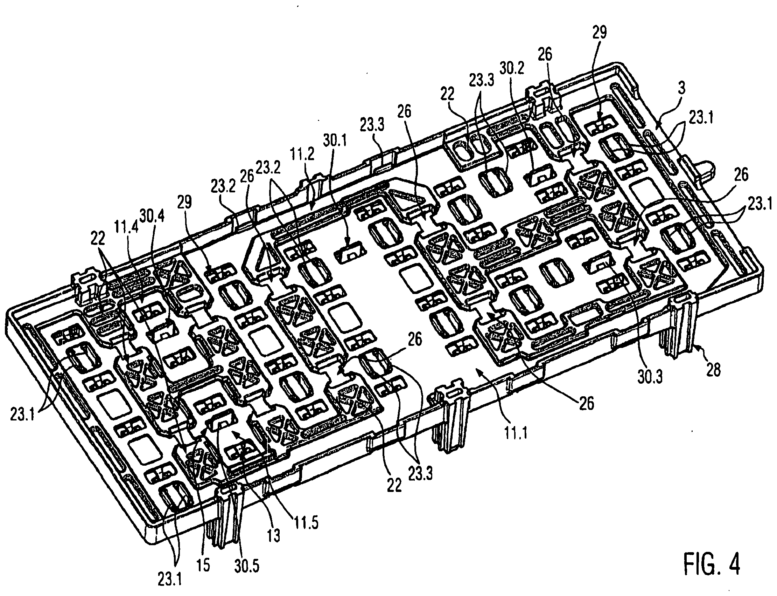

Anschließend wird durch ein Trennwerkzeug, beispielsweise durch ein Stanzwerkzeug eine Trennbearbeitung durchgeführt, in deren Rahmen die Verbindungsstege 12 getrennt werden. Ein Stanzstempel wird dabei durch die Stanzöffnungen eingebracht und die Verbindungsstege 12 abgeschert. Die Reste der Verbindungsstege 12 sind insbesondere in Figur 4 im Bereich der Stanzöffnungen 26 zu erkennen. Es ergeben sich fünf elektrisch jeweils voneinander isoliert vorgesehene Flächenelemente 11.1 bis 11.5.

Danach werden die Flachstecker 30 von der Oberseite 2 in die jeweiligen Einführkanäle 27.1 der zugeordneten Flachsteckerhalter 27 eingeführt. Im Rahmen dieser Einführbewegung werden die Verriegelungsvorsprünge 32 elastisch zurück in die Ebene des Flachsteckermaterials 30 zurückgedrängt. Die Spitze des Flachsteckers 30 drückt schließlich gegen die Kontaktfedern 14 der Flachsteckeraufnahmen 15, so dass die Kontaktfedern 14 der zunächst wie die Kontaktzungenaufnahmen 13 ausgebildeten Flachsteckeraufnahmen 15, die die Oberseite 2 der Metallplatte 10 überragend, mitgenommen und die Unterseite 3 überragend umbogen werden. Die genaue Führung der Flachstecker 30 durch die Einführkanäle 27.1 vereinfacht diese Umformbewegung der Kontaktfedern 14. Das Eindrücken der Flachstecker 30 erfolgt üblicherweise maschinell. Die Einschiebebewegung der Flachstecker endet, wenn die Steckanschläge 33 gegen den Grund der Nut 27.3 des Flachsteckerhalters 27 stoßen. Diese Position ist in Figur 5 in der Schnittdarstellung dargestellt.

Das so vorbereitete Plattenelement 1 wird danach auf die Kontaktzungen der einzelnen elektrischen Heizelemente aufgeschoben, um diese gemäß den Flächenelementen 11.1 bis 11.5 zu Heizkreisen zu gruppieren. Eine der Kontaktzungen der jeweiligen elektrischen Heizelemente wird dabei immer mit dem Flächenelement 11.1 kontaktiert, welches auf Masse liegt, wohingegen die anderen Flächenelemente 11.2 bis 11.4 über den zugeordneten Flachstecker 30.2 bis 30.5 an Schalter, insbesondere Leistungsschalter angeschlossen sind, die mit einer Leiterplatte verlötet sind, die auf den Auflagern 28 und den stirnseitigen Enden der Flachsteckerhalter 27 aufliegt und Flachsteckeraufnahmen zur elektrischen Kontaktierung der Flachstecker 30 mit der Leiterbahn hat (vgl. EP 1 872 986 A1).

Es sei darauf hingewiesen, dass mit dem Ausführungsbeispiel auf einfache Weise die Heizkreise verändert werden können, indem auf das vollständige Entfernen sämtlicher Verbindungsstege 12 verzichtet wird.

### Bezugszeichenliste

- 1: Plattenelement
- 2: Oberseite
- 3: Unterseite
- 10: Metallplatte
- 11: Flächenelement
- 11.1 - 11.5: Flächenelement der einzelnen Heizkreise
- 12: Verbindungssteg
- 13: Kontaktzungenaufnahme
- 14: Kontaktfeder
- 15: Flachsteckerkontaktaufnahme
- 16: Halteöffnung
- 17: Innenöffnung
- 18: Leiterbahnen
- 20: Trägerplatte
- 21: Anlagefläche
- 22: Versteifungssegment
- 23: Federstege
- 24: Rastnase
- 25: Halteelementsteg
- 26: Stanzöffnung
- 27: Flachsteckerhalter
- 27.1: Einführkanal
- 27.2: Aufnahmebereich
- 27.3: Nut
- 28: Auflage
- 29: Kontakteinbringöffnung
- 30: Flachstecker
- 31: Seitenfläche
- 32: Verriegelungsvorsprung
- 33: Steckanschlag

## Patentansprüche

1. Elektrische Heizvorrichtung mit mehreren elektrischen Heizelementen, die von einem Gehäuse gehalten werden und an Wärmeleitflächen anliegen, die von zu erwärmendem Medium anströmbar sind, wobei die elektrischen Heizelemente für den elektrischen Anschluss Kontaktzungen aufweisen, wobei im Wesentlichen höhengleich angeordnete Kontaktzungen über ein Leiterbahnen (18) und zur elektrischen Kontaktierung der Kontaktzungen ausgebildete Kontaktzungenaufnahmen (13) aufweisendes Plattenelement (1) angeschlossen sind, **dadurch gekennzeichnet,**
**dass** das Plattenelement (1) eine Trägerplatte (20) und eine stanzbearbeitete Metallplatte (10) umfasst, wobei die Trägerplatte (20) und die stanzbearbeitete Metallplatte (10) miteinander verbunden sind, wobei die Leiterbahnen (18) durch die stanzbearbeitete Metallplatte (10) ausgeformt sind und wobei die Metallplatte (10) mit der Trägerplatte (20) über an der Trägerplatte (20) einteilig ausgeformte Halteelemente (23) verrastet ist.

2. Elektrische Heizvorrichtung nach Anspruch 1, **dadurch gekennzeichnet, dass** die Kontaktzungenaufnahmen (13) einteilig durch Stanzen und Biegen an der Metallplatte (10) ausgeformt sind.

3. Elektrische Heizvorrichtung nach Anspruch 1 oder 2, **dadurch gekennzeichnet, dass** die Kontaktzungenaufnahmen (13) jeweils an gegenüberliegenden Seitenflächen der Kontaktzungen anlegbare Kontaktfedern (14) aufweisen.

4. Elektrische Heizvorrichtung nach einem der vorherigen Ansprüche, **dadurch gekennzeichnet, dass** die Trägerplatte (20) von zumindest einem Flachstecker (30) überragt ist, der von einem einteilig an der Trägerplatte (20) angeformten Flachsteckerhalter (27) gehalten ist.

5. Elektrische Heizvorrichtung nach Anspruch 4, **dadurch gekennzeichnet, dass** dem Flachstecker (30) eine an der Metallplatte (10) ausgebildete Flachsteckerkontaktaufnahme (15) zugeordnet und mittels Steckverbindung kontaktiert ist.

6. Elektrische Heizvorrichtung nach Anspruch 4 oder 5, **dadurch gekennzeichnet, dass** der Flachstecker (30) aus einem Blechstreifen gebildet ist und zumindest einen von der Seitenfläche (31) abragenden und durch Stanzen und Biegen hergestellten Verriegelungsvorsprung (32) aufweist, der mit dem Flachsteckerhalter (27) verrastet ist.

7. Elektrische Heizvorrichtung nach Anspruch 1 **gekennzeichnet durch** eine zu dem Halteelement (23) ausgesparte Halteöffnung (16), die von dem Halteelement (23) zum Verrasten gegen die Metallplatte (10) durchsetzt ist.

8. Elektrische Heizvorrichtung nach Anspruch 7, **dadurch gekennzeichnet, dass** die Halteöffnung (16) im Wesentlichen mittig von einem Halteelementsteg (25) der Trägerplatte (20) überbrückt ist, von dem beidseitig daran angeformte Federstege (23) mit die Metallplatte (10) hintergreifenden Rastnasen (24) abragen.

9. Elektrische Heizvorrichtung nach einem der Ansprüche 4 bis 6, **dadurch gekennzeichnet, dass** die Metallplatte (10) mehrere, einem Heizkreis der elektrischen Heizvorrichtung zugeordnete und die Leiterbahnen gruppierende Flächenelemente (11) ausbildet, die zunächst durch Verbindungsstege (12) miteinander verbunden und als Bestandteil einer einteiligen Metallplatte hergestellt sind, wobei einzelnen Flächenelementen (11) jeweils zumindest einer der Flachstecker (30) zugeordnet ist und dass die Trägerplatte (20) die Verbindungsstege (12) freilassende Stanzöffnungen (26) ausbildet.

## Claims

1. Electrical heating device with a plurality of electrical heating elements, which are held by a housing and abut heat conducting surfaces, over which a medium to be heated flows, wherein the electrical heating elements comprise contact lugs for the electrical connection, wherein contact lugs, arranged essentially at the same height, are connected through a plate element (1) comprising conductor strips (18) and contact lug receptacles (13) formed for the electrical contact of the contact lugs,
**characterised in that**
the plate element (1) comprises a carrier plate (20) and a stamped out metal plate (10) wherein the carrier plate (20) and the stamped out metal plate (10) are connected together, wherein the conductor strips (18) are formed by the stamped out metal plate (10) and wherein the metal plate (10) is locked to the carrier plate (20) through retaining elements (23) formed as one part on the carrier plate (20).

2. Electrical heating device according to Claim 1, **characterised in that** the contact lug receptacles (13) are formed as one part by stamping and bending on the metal plate (10).

3. Electrical heating device according to Claim 1 or 2, **characterised in that** the contact lug receptacles (13) each comprise contact springs (14) which can abut oppositely situated lateral faces of the contact lugs.

4. Electrical heating device according to one of the previous claims, **characterised in that** the carrier plate (20) has at least one flat plug (30), which is held by a flat plug holder (27) formed as one part on the carrier plate (20), extending over it.

5. Electrical heating device according to Claim 4, **characterised in that** a flat plug contact receptacle (15) formed on the metal plate (10) is assigned to the flat plug (30) and contacted by means of plug connection.

6. Electrical heating device according to claim 4 or 5, **characterised in that** the flat plug (30) is formed from a sheet metal strip and comprises at least one locking protrusion (32) which protrudes from the lateral face (31), is manufactured by stamping and bending and is locked with the flat plug holder (27).

7. Electrical heating device according to Claim 1, **characterised by** a retaining opening (16), which is formed for the retaining element (23) and which has the retaining element (23) passing through it for latching against the metal plate (10).

8. Electrical heating device according to Claim 7, **characterised in that** the retaining opening (16) is bridged essentially centrally by a retaining element ridge (25) of the carrier plate (20), from which spring bars (23) formed on both sides of it protrude downwards with the latching lugs (24) gripping behind the metal plate (10).

9. Electrical heating device according to one of the claims 4 to 6, **characterised in that** the metal plate (10) forms a plurality of area elements (11), which are assigned to a heating circuit of the electrical heating device, group the conductive paths, are initially connected to one another by connecting ridges (12) and are manufactured as a constituent part of a single-part metal plate, wherein at least one of the flat plugs (30) is assigned to single area elements (11) and that the carrier plate (20) forms the stamped openings (26) which leave the connecting ridges (12) free.

## Revendications

1. Dispositif de chauffage électrique comportant plusieurs éléments chauffants électriques, qui sont maintenus par un boitier et s'appuient contre des surfaces conductrices de la chaleur pouvant être soumises à l'écoulement d'un agent à échauffer, les éléments chauffants électriques présentant des languettes de contact pour le raccordement électrique, des languettes de contact agencées sensiblement à la même hauteur étant raccordées par l'intermédiaire d'un élément de plaque (1), qui comporte des pistes conductrices (18) et des logements d'accueil de languettes de contact (13) configurés pour assurer le contact électrique avec les languettes de contact,
**caractérisé**
**en ce que** l'élément de plaque (1) comprend une plaque de support (20) et une plaque métallique (10) usinée par découpage-poinçonnage, la plaque de support (20) et la plaque métallique (10) usinée par découpage-poinçonnage sont reliées l'une à l'autre, les pistes conductrices (18) étant formées par la plaque métallique (10) usinée et la plaque métallique (10) étant verrouillée à la plaque de support (20) par l'intermédiaire d'éléments de maintien (23) formés d'une seule pièce sur la plaque de support (20).

2. Dispositif de chauffage électrique selon la revendication 1, **caractérisé en ce que** les logements d'accueil de languettes de contact (13) sont formés d'un seul tenant par découpage-poinçonnage sur la plaque métallique (10).

3. Dispositif de chauffage électrique selon la revendication 1 ou 2, **caractérisé en ce que** les logements d'accueil de languettes de contact (13) comportent chacun des ressorts de contact (14) pouvant s'appliquer respectivement contre des surfaces latérales opposées des languettes de contact.

4. Dispositif de chauffage électrique selon l'une quelconque des revendications précédentes, **caractérisé en ce que** la plaque de support (20) dépasse au moins une fiche de connexion plate (30), qui est maintenue par un support de fiche de connexion plate (27) formé d'un seul tenant sur la plaque de support (20).

5. Appareil de chauffage électrique selon la revendication 4, **caractérisé en ce qu'**à la fiche de connexion plate (30) est associée un logement de fiche de connexion plate (15) formée sur la plaque métallique (10), et le contact se faisant par une liaison par enfichage.

6. Dispositif de chauffage électrique selon la revendication 4 ou 5, **caractérisé en ce que** la fiche de connexion plate (30) est formée par une bande de tôle et présente au moins une protubérance de verrouillage (32), qui fait saillie de la surface latérale (31) et qui est fabriquée par découpage-poinçonnage et pliage, et qui est encliquetée avec le support de fiche de connexion plate (27).

7. Dispositif de chauffage électrique selon la revendication 1, **caractérisé par** une ouverture de maintien (16) évidée en correspondance avec l'élément de maintien (23) et traversée par l'élément de maintien (23) pour assurer l'encliquetage contre la plaque métallique (10).

8. Appareil de chauffage électrique selon la revendication 7, **caractérisé en ce que** l'ouverture de maintien (16) est pontée, sensiblement en son milieu, par une nervure d'élément de maintien (25) de la plaque support (20), de laquelle font saillie des nervures élastiques (23) formées des deux côtés de celle-ci, des talons d'encliquetage (24) s'engageant sous la plaque métallique (10).

9. Dispositif de chauffage électrique selon l'une des revendications 4 à 6, **caractérisé en ce que** la plaque métallique (10) forme plusieurs éléments de surface (11), qui sont associés à un circuit de chauffe du dispositif de chauffage électrique et regroupent les pistes conductrices, qui sont tout d'abord reliés mutuellement par des nervures de liaison (12) et sont fabriqués en tant que partie intégrante d'une plaque métallique d'un seul tenant, au moins l'une des fiches de connexion plate (30) étant respectivement associée à des éléments de surface (11) individuels, et **en ce que** la plaque de support (20) forme des ouvertures de découpage-poinçonnage (26) dégageant les nervures de liaison (12).
